# EUROPEAN PATENT APPLICATION

(11) **EP 4 495 999 A2**
(43) Date of publication of application: **22.01.2025**
(21) Application number: 24189412.0
(22) Date of filing: 18.07.2024
(51) Int. Cl.: H01L 27/02, H01L 21/8238, H01L 23/528, H01L 27/118

(54) **CELL ARCHITECTURE OF SEMICONDUCTOR DEVICE INCLUDING SEMICONDUCTOR CELLS CONNECTED BASED ON BACKSIDE POWER DISTRIBUTION NETWORK**

(30) Priority: 20.07.2023 US 202363527957 P; 12.12.2023 US 202318537211
(71) Applicant: Samsung Electronics Co., Ltd., Suwon-si, Gyeonggi-do 16677 (KR)
(72) Inventor: KIM, Jintae, San Jose, CA, 95134 (US); PARK, Panjae, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Provided is a semiconductor device based on a cell architecture which includes: a 1^{st} semiconductor cell (400A); and a 2^{nd} semiconductor cell (400B) which is connected to the 1^{st} semiconductor cell (400A) in a 1^{st} direction (D1) such that an output pin of the 1^{st} semiconductor cell (400A) is connected to an input pin of the 2^{nd} semiconductor cell (400B), wherein the 2^{nd} semiconductor cell (400B) is in a form in which the 1^{st} semiconductor cell (400A) is turned upside down.

## Description

### BACKGROUND

### 1. Filed

Apparatuses consistent with example embodiments of the disclosure relate to a semiconductor cell architecture including a backside power distribution network.

### 2. Description of Related Art

An integrated circuit includes a plurality of logic circuits (or logic gates) which implement one or more logic operations or functions such as AND, OR, NOT (inverter), NAND, NOR, XOR, XNOR, AOI, multiplexer, and their combination, not being limited thereto. These logic circuits are building blocks of the integrated circuit.

In the integrated circuit, one logic circuit is often repeatedly arranged to implement a desired circuit. Thus, a semiconductor cell that implements this logic circuit therein is often repeatedly arranged in designing a cell architecture for a semiconductor device. For example, two semiconductor cells each implementing a same inverter circuit may be arranged adjacent to each other in a cell-length direction and connected to each other such that an output signal from an output pin of one semiconductor cell is input to an input pin of the other semiconductor cell as an input signal thereof to design a cell architecture of a desired integrated circuit. However, connecting two same semiconductor cells for signal routing in the integrated circuit requires one or more of additional interconnect structures such as metal lines and vias, which may lengthen a signal routing path, thereby increasing contact resistance and device complexity. Thus, reducing a length of a signal routing path in a cell architecture for a semiconductor device is directly related to increasing a device performance and a device area gain.

Herein, the term "semiconductor cell" may include a "standard cell" of or for a cell library used in designing an integrated circuit or a cell architecture for a semiconductor device. The semiconductor cell for an integrated circuit may include one or more active regions and gate structures forming one or more of passive devices and transistors configured to perform a logic operation or function.

Information disclosed in this background section has already been known to the inventors before achieving the embodiments of the present application or is technical information acquired in the process of achieving the embodiments described herein. Therefore, it may contain information that does not form prior art that is already known to the public.

### SUMMARY

Various example embodiments provide a semiconductor device manufactured based on a cell architecture which is formed by connecting a plurality of semiconductor cells each of which implements a same logic circuit based on a backside power distribution network (BSPDN), in which each semiconductor cell is in a form of turning upside down an adjacent semiconductor cell, and an output pin of the semiconductor cell is connected to an input pin of the adjacent semiconductor cell.

According to embodiments, there is provided a semiconductor device based on a cell architecture which may include: a 1^{st} semiconductor cell; and a 2^{nd} semiconductor cell which is connected to the 1^{st} semiconductor cell in a 1^{st} direction such that an output pin of the 1^{st} semiconductor cell is connected to an input pin of the 2^{nd} semiconductor cell, wherein the 2^{nd} semiconductor cell is in a form in which the 1^{st} semiconductor cell is turned upside down (the configuration of the 2^{nd} semiconductor cell may be created by mirroring the configuration of the first semiconductor cell on a plane parallel to the first direction).

According to embodiments, the output pin of the 1^{st} semiconductor cell may include a 1^{st} metal line, and the input pin of the 2^{nd} semiconductor cell may include a 2^{nd} metal line, wherein at least one the 1^{st} and 2^{nd} metal lines is extended in the 1^{st} direction, and wherein the 1^{st} metal line and the 2^{nd} metal line are connected to each other.

According to embodiments, each of the 1st and 2nd semiconductor cells may comprise a source/drain region connected to a backside power rail formed at a back side of the cell architecture.

According to embodiments, the 1^{st} semiconductor cell may comprise a 1^{st} portion and a 2^{nd} portion below the 1^{st} portion in a 2^{nd} direction intersecting the 1^{st} direction, wherein the 1^{st} portion comprises a 1^{st} source/drain region and a 1^{st} interconnect structure, and the 2^{nd} semiconductor cell may comprise a 3^{rd} portion and a 4^{th} portion below the 3^{rd} portion in the 2^{nd} direction, wherein the 4^{th} portion comprises a 2^{nd} source/drain region and a 2^{nd} interconnect structure, and wherein the 1^{st} portion is the same as or symmetrical to the 4^{th} portion.

According to embodiments, the 1^{st} portions and the 3^{rd} portion may respectively be divided from the 2^{nd} portion and the 4^{th} portion by a virtual horizontal center line extended in the 1^{st} direction on the 1^{st} and 2^{nd} semiconductor cells.

According to embodiments, the semiconductor device may further include: a 1^{st} backside power rail along a 1^{st} boundary of the cell architecture; a 2^{nd} backside power rail along a virtual center line of the cell architecture; and a 3^{rd} backside power rail along a 2^{nd} boundary of the cell architecture opposite to the 1^{st} boundary in a 2^{nd} direction intersecting the 1^{st} direction, wherein the 1^{st} to 3^{rd} backside power rails are extended in the 1^{st} direction.

According to embodiments, the 1^{st} and 3^{rd} backside power rails may be connected to a 1^{st} voltage source, and the 2^{nd} backside power rail may be connected to a 2^{nd} voltage source different from the 1^{st} voltage source.

According to embodiments, the 1^{st} semiconductor cell may comprise a 1^{st} transistor comprising a 1^{st} source/drain region, and a 2^{nd} transistor comprising a 2^{nd} source/drain region, the 2^{nd} semiconductor cell may comprise a 3^{rd} transistor comprising a 3^{rd} source/drain region and a 4^{th} transistor comprising a 4^{th} source/drain region, wherein the 1^{st} source/drain region is connected to the 1^{st} backside power rail, and the 4^{th} source/drain region is connected to the 3^{rd} backside power rail, and wherein the 2^{nd} and 3^{rd} source/drain regions are connected to the 2^{nd} backside power rail.

According to embodiments, the 1^{st} and 2^{nd} semiconductor cells may comprise (or implement) a same logic circuit.

According to embodiments, there is provided a semiconductor device based on cell architecture which may include: a 1^{st} semiconductor cell; a 2^{nd} semiconductor cell which is connected to the 1^{st} semiconductor cell such that an output pin of the 1^{st} semiconductor cell is connected to an input pin of the 2^{nd} semiconductor cell in a 1^{st} direction; and at least one backside power rail formed at a back side of the cell architecture, wherein the 1^{st} semiconductor cell and the 2^{nd} semiconductor cell include a same logic circuit, and the 1^{st} semiconductor cell and the 2^{nd} semiconductor cell are both connected to at least one backside power rail.

According to embodiments, the 2^{nd} semiconductor cell may be in a form in which the 1^{st} semiconductor cell is turned upside down.

According to embodiments, the output pin and the input pint may be aligned with each other in the 1^{st} direction.

According to embodiments, the at least one backside power rail may comprise: a 1^{st} backside power rail along a 1^{st} boundary of the cell architecture; a 2^{nd} backside power rail along a virtual center line of the cell architecture; and a 3^{rd} backside power rail along a 2^{nd} boundary of the cell architecture opposite to the 1^{st} boundary in a 2^{nd} direction intersecting the 1^{st} direction, wherein the 1^{st} to 3^{rd} backside power rails are extended in the 1^{st} direction.

According to embodiments, the 1^{st} semiconductor cell may comprise a 1^{st} portion and a 2^{nd} portion below the 1^{st} portion in a 2^{nd} direction intersecting the 1^{st} direction, the 1^{st} portion comprising a 1^{st} source/drain region and a 1^{st} interconnect structure, and the 2^{nd} semiconductor cell may comprise a 3^{rd} portion and a 4^{th} portion below the 3^{rd} portion in the 2^{nd} direction, wherein the 4^{th} portion comprises a 2^{nd} source/drain region and a 2^{nd} interconnect structure, and wherein the 1^{st} portion is symmetrical to the 4^{th} portion.

According to embodiments, the output pin of the 1^{st} semiconductor cell may comprise a 1^{st} metal line, and the input pin of the 2^{nd} semiconductor cell may comprise a 2^{nd} metal line, and at least one the 1^{st} and 2^{nd} metal lines may be extended in the 1^{st} direction, and the 1^{st} and 2^{nd} metal lines may be connected to each other.

According to embodiments, the 1^{st} metal line may be on one of the 1^{st} and 2^{nd} portions, and the 2^{nd} metal line may be on one of the 3^{rd} and 4^{th} portions aligned with the one of the 1^{st} and 2^{nd} portions in the 1^{st} direction.

According to embodiments, there is provided a semiconductor device based on a cell architecture which may include: a 1^{st} semiconductor cell; and a 2^{nd} semiconductor cell adjacent and connected to the 1^{st} semiconductor cell in a 1^{st} direction, wherein the 1^{st} semiconductor cell includes a 1^{st} portion and a 2^{nd} portion below the 1^{st} portion in a 2^{nd} direction intersecting the 1^{st} direction, the 1^{st} portion including a 1^{st} source/drain region and a 1^{st} interconnect structure, wherein the 2^{nd} semiconductor cell includes a 3^{rd} portion and a 4^{th} portion below the 3^{rd} portion in the 2^{nd} direction, the 4^{th} portion including a 2^{nd} source/drain region and a 2^{nd} interconnect structure, and wherein the 1^{st} portion is symmetrical to the 4^{th} portion.

According to embodiments, the 1^{st} and the 2^{nd} semiconductor cells may comprise (or implement) a same logic circuit, and a polarity of the 1^{st} source/drain region in the 1^{st} portion may be the same as a polarity of the 2^{nd} source/drain region in the 4^{th} portion.

According to embodiments, the semiconductor device may further include a 3^{rd} semiconductor cell adjacent and connected to the 2^{nd} semiconductor cell in the 1^{st} direction, wherein the 1^{st} to 3^{rd} semiconductor cells include a same logic circuit, and wherein an output pin of the 1^{st} semiconductor cell is connected to an input pin of the 2^{nd} semiconductor cell, and an output pin of the 2^{nd} semiconductor cell is connected to an input pin of the 3^{rd} semiconductor cell.

### BRIEF DESCRIPTION OF DRAWINGS

Example embodiments of the disclosure will be more clearly understood from the following detailed description taken in conjunction with the accompanying drawings in which:
FIG. 1A illustrates a schematic of an inverter circuit, and FIG. 1B is a top plan view of a semiconductor cell in which the inverter circuit of FIG. 1A is implemented, according to an embodiment;
FIG. 2A is a schematic of a buffer circuit in which two of the inverter circuits 10 of FIG. 1A are connected to each other, and FIG. 2B is a schematic of a top plan view of a cell architecture in which the buffer circuit of FIG. 2A is implemented, according to an embodiment;
FIG. 3 is a top plan view of a cell architecture in which the buffer circuit of FIG. 2A is implemented, according to another embodiment;
FIG. 4A is a top plan view of a semiconductor cell of the inverter circuit shown in FIG. 1A based on a backside power distribution network (BSPDN), according to an embodiment, FIG. 4B is a top plan view of a cell architecture in which the buffer circuit of FIG. 2A is implemented, according to still another embodiment, and FIG. 4C is a top plan view of a cell architecture in which a different buffer circuit is implemented, according to an embodiment; and
FIG. 5 is a schematic block diagram illustrating an electronic device including at least one semiconductor device based on at least one of the semiconductor cell 40 and the cell architectures 400 and 400' shown in FIGS. 4A-4C, according to embodiments.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, elements described as "below" or "beneath" other elements would then be oriented "above" the other elements. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of a semiconductor device including a nanosheet transistor and a fin field-effect transistor (FinFET) and materials forming the same may or may not be described in detail herein. For example, a certain isolation layer or structure of a semiconductor device and materials forming the same may be omitted herein when this layer or structure is not related to the novel features of the embodiments.

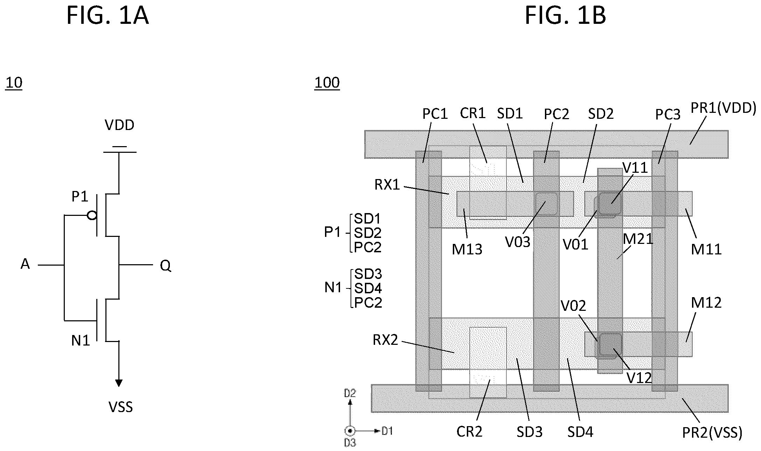

FIG. 1A illustrates a schematic of an inverter circuit, and FIG. 1B is a top plan view of a semiconductor cell in which the inverter circuit of FIG. 1A is implemented, according to an embodiment.

A semiconductor cell and a cell architecture including one or more of the semiconductor cells described herein may be a basis for manufacturing a semiconductor device. Thus, the semiconductor cell and the cell architecture may include the same structural elements of the semiconductor device, and a front side and a back side of the semiconductor cell and the cell architecture described herein may indicate a front side and a back side of the semiconductor device manufactured based on the semiconductor cell and the cell architecture.

Referring to FIG. 1A, an inverter circuit 10 may include a p-type metal-oxide-semiconductor field-effect transistor (PMOS) P1 and an n-type metal-oxide-semiconductor field-effect transistor (NMOS) N1 to form a complimentary metal-oxide-semiconductor (CMOS) device.

In the inverter circuit 10, a source terminal of the PMOS P1 is connected to a 1^{st} voltage source (e.g., VDD), and a source terminal of the NMOS N1 is connected to a 2^{nd} voltage source (e.g., VSS), providing a lower voltage than the 1^{st} voltage source, or grounded. Further, gate terminals of the PMOS P1 and the NMOS N1 are connected to each other to receive a common gate input signal A, which is also referred to as an input signal A of the inverter circuit 10, and drain terminals of the PMOS P1 and the NMOS N1 are connected to each other to generate an output signal Q of the inverter circuit 10.

Referring to FIG. 1B, a semiconductor cell 100, in which the inverter circuit 10 of FIG. 1A is implemented, may include a 1^{st} active region RX1 and a 2^{nd} active region RX2 extended in a D1 direction and arranged in a D2 direction, and a plurality of gate structures PC1, PC2 and PC3 which are extended in the D2 direction and arranged in the D1 direction across the active regions RX1 and RX2. At least the gate structure PC2 may be provided for formation of a gate electrode thereon for the PMOS P1 and the NMOS N1. The active regions RX1 and RX2 may be provided for formation of source/drain regions and channel structures of the PMOS P1 and the NMOS N1 of the inverter circuit 10 of FIG. 1A. Herein, the D1 direction is a cell-length direction or a channel-length direction in which a current flows between source/drain regions through a channel structure in a transistor. The D2 direction, which intersects the D1 direction, is a cell-height direction and a channel-width direction in which a width of a channel structure is measured. The D1 and D2 directions both intersect a D3 direction, which is a vertical direction.

On the 1^{st} active region RX1 may be formed two source/drain regions SD1 and SD2, which may be doped with p-type impurities such as boron (B), gallium (Ga) and/or indium (In). On the 2^{nd} active region RX2 may be formed two source/drain regions SD3 and SD4, which may be doped with n-type impurities such as phosphorus (P), arsenic (As) and/or antimony (Sb).

Referring to FIGS. 1A and 1B, the source/drain regions SD1 and SD2 may correspond to the source terminal and the drain terminal of the PMOS P1, respectively, and the source/drain regions SD3 and SD4 may correspond to the source terminal and the drain terminal of the NMOS N1. The source/drain regions SD1 and SD2 may be connected to each other through a channel structure formed below the gate structure PC2 corresponding to the gate terminal of the PMOS P1, and the source/drain regions SD3 and SD4 may be connected to each other through a channel structure formed below the gate structure PC2 corresponding to the gate terminal of the NMOS N1. The gate structures PC1 and PC3 in the semiconductor cell 100 may each be a dummy gate structure in the semiconductor cell 100. The source/drain regions SD1-SD4, the gate structures PC1-PC3, and the channel structures surrounded by the gate structure PC2 may be referred to as front-end-of-line (FEOL) structures of the semiconductor cell 100 and a semiconductor device formed based on the semiconductor cell 100.

Further, the semiconductor cell 100 may include two front power rails PR1 and PR2 extended in the D1 direction at upper and lower boundaries of the semiconductor cell 100, respectively. The two cell boundaries may define a cell height of the semiconductor cell 100. The front power rail PR1 may connect the source/drain region SD1 of the PMOS P1 to the 1^{st} voltage source through a contact structure CR1, and the front power rail PR2 may connect the source/drain region SD3 of the NMOS N1 to the 2^{nd} voltage source through a contact structure CR2, respectively. The contact structures CR1 and CR2 may be referred to as middle-of-line (MOL) structures of a semiconductor device manufactured based on the semiconductor cell 100.

The semiconductor cell 100 may include a plurality of interconnect structures for signal routing to implement the inverter circuit 10 of FIG. 1A. The interconnect structures may include metal lines M11-M13 formed at a 1^{st} metal layer, and a metal line M21 formed at a 2^{nd} metal layer above the 1^{st} metal layer in the D3 direction. The front power rails PR1 and PR2 may also be formed at the same 1^{st} metal layer where the metal lines M11-M13 are formed, not being limited thereto. The interconnect structures may also include a plurality of vias V01-V03, V11 and V12 formed above or below the metal lines. Each of these vias may connect two elements among the metal lines M11-M13, M21 and the FEOL structures to each other. In FIG. 1B, the via V01 is seen as partially overlapped by the via V11 in a D3 direction. However, this partial overlapping is depicted only to show that the via V01 is formed below the via V11 with the metal line M11 therebetween. Thus, in reality, the via V01 may be either partially or entirely overlapped by the via V11 in the D3 direction. Similarly, the via V02 may be either partially or entirely overlapped by the via V12 in the D3 direction. These interconnect structures may be referred to as back-end-of-line (BEOL) structures.

In order for the semiconductor cell 100 to implement the inverter circuit 10, the metal line M13 may be connected to the gate structure PC2 through the via V03 formed thereon to receive the common gate input signal A for the PMOS P1 and the NMOS N1. Here, the metal line M13 functions as an input pin of the semiconductor cell 100. The metal line M11 may be connected to the source/drain regions SD2 of the PMOS P1 through the via V01, and the metal line M12 may be connected to the source/drain regions SD4 of the NMOS N1 through the via V02. The two source/drain regions SD2 and SD4 may be connected to each other through the vias V11 and V12, respectively, connected to the metal line M21 to generate the output signal Q of the inverter circuit 10. Here, the output signal Q may be output to an external circuit through at least one of the metal lines M11, M12 and M21. For example, the output signal Q may be output to an external circuit through the metal line M12 as an output pin of the semiconductor cell 100.

Each of the PMOS P1 and the NMOS N1 implemented in the semiconductor cell 100 may be a FinFET or a nanosheet transistor, not being limited thereto. The FinFET has one or more fin structures as a channel structure of the transistor. The fin structures vertically protrude from a base layer such as a substrate and horizontally extend, and at least three surfaces thereof are surrounded by a gate structure. The nanosheet transistor is characterized by one or more nanosheet channel layers as a channel structure of the transistor. The nanosheet channel layers vertically stacked based on a substrate and horizontally extend, and all four surfaces of each of the nanosheet channel layers are surrounded by a gate structure. The nanosheet transistor is referred to as gate-all-around (GAA) transistor, or as a multi-bridge channel field-effect transistor (MBCFET).

In the above manner, the semiconductor cell 100 may implement therein the inverter circuit 10 as shown in FIG. 1A.

As described earlier, a logic circuit such as the inverter circuit 10 of FIG. 1A is often repeatedly arranged to form a desired circuit in an integrated circuit. Thus, a cell architecture for a semiconductor device in which the repeatedly arranged logic circuits may include a plurality of semiconductor cells implementing these logic circuits to be arranged adjacent to each other in a cell-length direction and connected to each other.

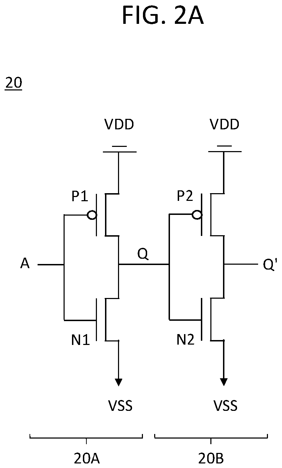

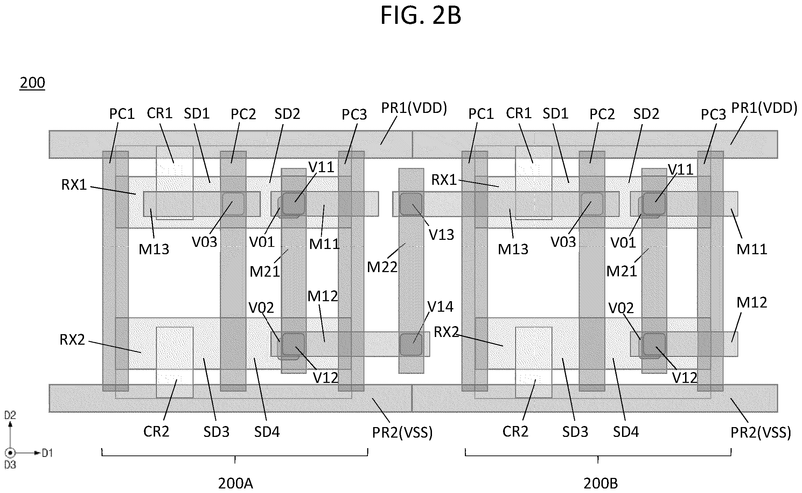

FIG. 2A is a schematic of a buffer circuit in which two of the inverter circuits 10 of FIG. 1A are connected to each other, and FIG. 2B is a schematic of a top plan view of a cell architecture in which the buffer circuit of FIG. 2A is implemented, according to an embodiment.

Referring to FIG. 2A, a buffer circuit 20 may include a 1^{st} inverter circuit 20A which is the same as the inverter circuit 10 of FIG. 1A formed of the PMOS P1 and the NMOS N1, and a 2^{nd} inverter circuit 20B formed a PMOS P2 and an NMOS N2 which is also the same as the inverter circuit 10 of FIG. 1A. The buffer circuit 20 is formed such that an output node of the 1^{st} inverter circuit 20A is connected to an input node of the 2^{nd} inverter circuit 20B. Thus, the output signal Q of the 1^{st} inverter circuit 20A is input to the 2^{nd} inverter circuit 20B as an input signal thereof to generate an output signal Q' of the buffer circuit 20. In the buffer circuit 20, the 1^{st} inverter circuit 20A may be referred to as an input CMOS device, and the 2^{nd} inverter circuit 20B may be an output CMOS device.

FIG. 2B shows a cell architecture 200 which implements therein the buffer circuit 20 of FIG. 2A. In the cell architecture 200, a 1^{st} semiconductor cell 200A and a 2^{nd} semiconductor cell 200B each of which is the same as the semiconductor cell 100 of FIG. 1B are arranged adjacent to each other in the D1 direction and connected to each other such that an output pin of the 1^{st} semiconductor cell 200A is connected to an input pin of the 2^{nd} semiconductor cell 200B. The 1^{st} and 2^{nd} semiconductor cells 200A and 200B may implement therein the 1^{st} and 2^{nd} inverter circuits 20A and 20B of the buffer circuit 20 of FIG. 2A, respectively. Herein, one semiconductor cell being the same as another cell may mean that the two semiconductor cells have the same structural elements such as source/drain regions, gate structures, and interconnect structures, and further, their positional relationships in the semiconductor cells.

The connection of the two semiconductor cells 200A and 200B may be performed such that the metal line M12 of the 1^{st} semiconductor cell 200A as the output pin thereof and the metal line M13 of the 2^{nd} semiconductor cell 200B as the input pin thereof are extended to be close to each other in the D1 direction, and connected to each other through an additional metal line M22 formed at the 2^{nd} metal layer through additional vias V13 and V14 formed on the extended metal lines M12 and M13, respectively. Further, the front power rails PR1 and PR2 of the 1^{st} semiconductor cell 200A may be connected to the front power rails PR1 and PR2 of the 2^{nd} semiconductor cell 200B, respectively.

However, the addition of the metal lines M22 and the vias V13 and V14 to connect the 1^{st} semiconductor cell 200A to the 2^{nd} semiconductor cell 200B to each other as shown in FIG. 2B may lengthen a signal routing path resulting in increased contact resistance of a semiconductor device manufactured based on the cell architecture 200, which may deteriorate at least connection performance and a device area gain. Thus, another method of connecting two semiconductor cells implanting a same inverter circuit may be provided as below to improve the connection performance and the device area gain.

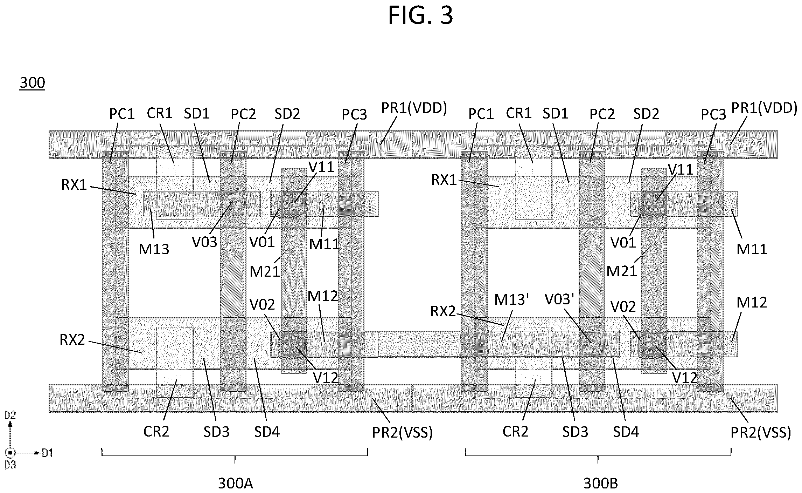

FIG. 3 is a top plan view of a cell architecture in which the buffer circuit of FIG. 2A is implemented, according to another embodiment.

Referring to FIG. 3, a 1^{st} semiconductor cell 300A and a 2^{nd} semiconductor cell 300B may be provided to be adjacent and connected to each other in the D1 direction to form a cell architecture 300 implementing the buffer circuit 20 of FIG. 2A. The 1^{st} and 2^{nd} semiconductor cells 300A and 300B may implement therein the 1^{st} and 2^{nd} inverter circuits 20A and 20B of the buffer circuit 20 shown in FIG, 2A, respectively. Further, like the cell architecture 200 of FIG. 2B, the cell architecture 300 may be configured such that an output pin of the 1^{st} semiconductor cell 300A is connected to an input pin of the 2^{nd} semiconductor cell 300B.

In the cell architecture 300, each of the semiconductor cell 300A and 300B may be the same as the semiconductor cell 100 of FIG. 1B except that, in the 2^{nd} semiconductor cell 300B, a position of a metal line M13' and a via V03' is different from a position of the respectively corresponding metal line M13 and via V03 of the semiconductor cell 100 as shown in FIG. 1B.

For example, the 1^{st} semiconductor cell 300A is configured such that the metal line M13 as an input pin thereof is formed above an upper part of the cell which includes the 1^{st} active region RX1. In contrast, the 2^{nd} semiconductor cell 300B is configured such that the corresponding metal line M13' as an input pin thereof may be formed above a lower part of the cell such that an extension of the metal line M13' may be connected to the metal line M12 of the 1^{st} semiconductor cell 300A which is an output pin thereof. Accordingly, the via V03' connecting the metal lime M13' to the gate structure PC2 may be formed on a lower part of the gate structure PC2 below the metal line M13' in the 2^{nd} semiconductor cell 300B while the corresponding via V03 is formed on an upper part of the gate structure PC2 in the 1^{st} semiconductor cell 300A.

Due to the above configuration of the cell architecture 300 in which the output pin of the 1^{st} semiconductor cell 300A including the meta line M12 is horizontally aligned with the input pin of the 2^{nd} semiconductor cell 300B including the metal line M13', additional interconnect structures such as the metal line M22 and the vias V13 and V14 can be dispensed with in designing the cell architecture 300, thereby shortening a signal routing path and reducing contact resistance.

However, as the 2^{nd} semiconductor cell 300B has different configuration and arrangement of its interconnect structures such as the metal line M13' and the via V03' compared to the 1^{st} semiconductor cell 300A which is the same as the semiconductor cell 100, a cell library may have to carry the semiconductor cell 300B as a variant cell of the semiconductor cell 100 or 300A for the same inverter circuit shown in FIG. 1A and an additional design kit for this variant cell. Then, a lot of resources are required in preparing, certifying and adding two different semiconductor cells or standard cells for the same logic circuit to a semiconductor cell library. Thus, the disclosure provides herebelow formation of a different cell architecture which correspond to the cell architectures 200 and 300, but do not require the variant cell and the additional design kit while shortening the signal routing path and reducing the contact resistance to improve the connection performance and the device area gain.

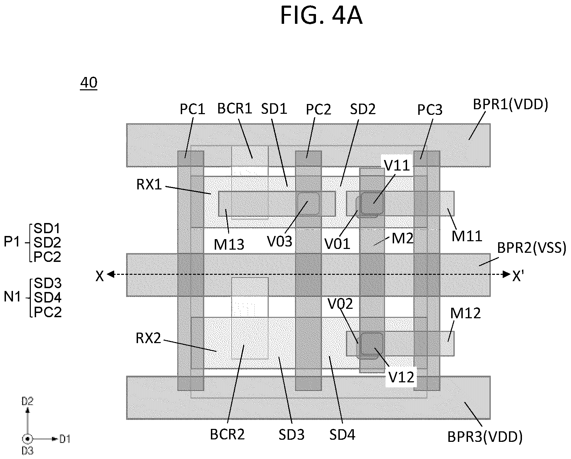

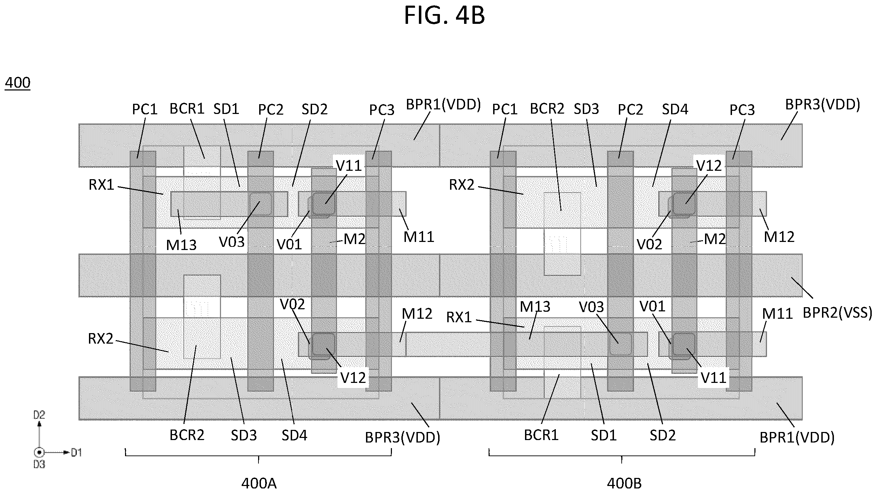

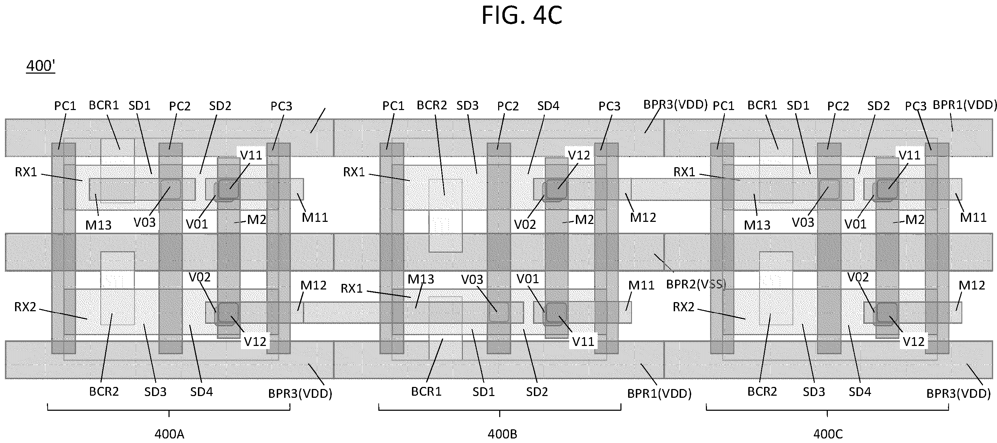

FIG. 4A is a top plan view of a semiconductor cell of the inverter circuit shown in FIG. 1A based on a backside power distribution network (BSPDN), according to an embodiment. FIG. 4B is a top plan view of a cell architecture in which the buffer circuit of FIG. 2A is implemented, according to still another embodiment. FIG. 4C is a top plan view of a cell architecture in which a different buffer circuit is implemented, according to an embodiment.

Referring to FIG. 4A, a semiconductor cell 40, in which the inverter circuit 10 of FIG. 1A is implemented, may have the same or similar structure as the semiconductor cell 100 of FIG. 1B except power rails and contact structures. Thus, while duplicate descriptions thereof may be omitted herein, different aspects of the semiconductor cell 40 are described herein.

The semiconductor cell 40 may include 1^{st} to 3^{rd} backside power rails BPR1, BPR2 and BPR3 formed at a back side thereof while the semiconductor cell 100 includes the front power rails PR1 and PR2 formed at a front side thereof. For example, the 1^{st} and 3^{rd} backside power rails BPR1 and BPR3 may be formed below upper and lower boundaries of the semiconductor cell 40, respectively, and connected to the 1^{st} voltage source (e.g., VDD), and the 2^{nd} backside power rail BPR2 may be formed below a horizontal center line X-X' of the semiconductor cell 40 between the 1^{st} and 3^{rd} backside power rails BPR1 and BPR3 and connected to the 2^{nd} voltage source (e.g., VSS). In contrast, the frontside power rails PR1 and PR2 of the semiconductor cell 100 may be formed above the upper boundary and the lower boundary of the semiconductor cell 100 as shown in FIG. 1B. When a semiconductor device is manufactured based on the semiconductor cell 40, the backside power rails BPR1-BPR3 may be formed at a back side of the semiconductor device which is vertically below FEOL structures in the D3 direction. For example, these backside power rails may be formed in a backside isolation structure that replaces a silicon substrate of the semiconductor device on which the FEOL structures are formed. In contrast, the frontside power rails PR1 and PR2 of the semiconductor cell 100 may be formed at a level of BEOL structures which is vertically above the FEOL structures when a semiconductor device is manufactured based on the semiconductor cell 100.

Frontside power rails formed at a front side of a semiconductor device are bound by a cell design rule for placement, size, spacing, clearance, etc. of FEOL, MOL and BEOL structures in a corresponding semiconductor cell or cell architecture. Thus, the positions of the frontside power rails PR1 and PR2 may be fixed at the upper and lower boundaries of the semiconductor cell 100 of FIG. 1B, respectively. However, placement of backside power rails may not be bound by the cell design rule which is strictly applied to the frontside power rails. Thus, in the semiconductor cell 40, the 1^{st} and 3^{rd} backside power rails BPR1 and BPR3 may be placed at the upper and lower boundaries of the semiconductor cell 40, respectively, and the 2^{nd} backside power rail BPR2 may be at around the horizontal center line X-X' of the semiconductor cell 40.

Based on the backside power rails BPR1-BPR3, the 1^{st} source/drain region SD1 of the PMOS P1 may be connected to the backside power rail BPR1 through a 1^{st} backside contact structure BCR1 formed on the 1^{st} source/drain region SD1, and the source/drain region SD3 of the NMOS N1 may be connected to the backside power rail BPR2 through a 2^{nd} backside contact structure BCR2 formed on the source/drain region SD3. The backside power rails BPR1-BPR3 and the backside contact structures BCR1-BCR2 may be formed in a backside isolation structure to form a backside power distribution network (BSPDN) for a semiconductor device to be manufactured based on the semiconductor cell 30.

Referring to FIG. 4B, a 1^{st} semiconductor cell 400A and a 2^{nd} semiconductor cell 400B may be provided to be adjacent and connected to each other in the D1 direction to form a cell architecture 400 implementing the buffer circuit 20 of FIG. 2A. The 1^{st} and 2^{nd} semiconductor cells 400A and 400B may implement therein the 1^{st} and 2^{nd} inverter circuits 20A and 20B of the buffer circuit 20 of FIG, 2A, respectively. Further, like the cell architectures 200 and 300 of FIGS. 2B and 3, the cell architecture 400 may be configured such that an output pin of the 1^{st} semiconductor cell 400A is connected to an input pin of the 2^{nd} semiconductor cell 400B.

In the cell architecture 400, the 1^{st} semiconductor cell 400A may be the same as the semiconductor cell 40 of FIG. 4A. However, the 2^{nd} semiconductor cell 400B is formed by simply turning upside down the semiconductor cell 40 along an axis corresponding to the horizontal center line X-X' shown in FIG. 4A.

As the 2^{nd} semiconductor cell 400B is obtained by turning upside down (or mirroring) the semiconductor cell 40 along the axis corresponding to the horizontal center line X-X', the 1^{st} backside power rail BPR1 disposed along the upper boundary in the semiconductor cell 40 may now be disposed along the lower boundary in the 2^{nd} semiconductor cell 400B. Likewise, the 3^{rd} backside power rail BPR3 disposed along the lower boundary in the semiconductor cell 40 may now be disposed along the upper boundary of the 2^{nd} semiconductor cell 400B. However, the 2^{nd} backside power rail BPR2 positioned along the horizontal center line X-X' may keep its position in the 2^{nd} semiconductor cell 400B. Further, the 1^{st} active region RX1, the source/drain regions SD1, SD2, and the interconnect structure including the 1^{st} backside contact structure BCR1, the metal lines M13, M11, and the via V03, V01 and V11 disposed between the 1^{st} and 2^{nd} backside power rails BPR1 and BPR2 in the semiconductor cell 40 are now disposed between the 2^{nd} and 3^{rd} backside power rails BPR1 and BPR2 in the semiconductor cell 400B. Likewise, the 2^{nd} active region RX2, the source/drain regions SD3, SD4, and the interconnect structure including the 2^{nd} backside contact structure BCR2, the metal line M12, the via V02 and V12 disposed between the 2^{nd} and 3^{rd} backside power rails BPR2 and BPR3 in the semiconductor cell 40 are now disposed between the 1^{st} and 2^{nd} backside power rails BPR2 and BPR3 in the 2^{nd} semiconductor cell 400B.

Thus, when the 2^{nd} semiconductor cell 400B takes a form or shape in which the semiconductor cell 40 (or the 1^{st} semiconductor cell 400A) is turned upside down (turned upside down may mean mirrored at a plane parallel to the first and third directions D1 and D3, or mirrored at a plane parallel to the first direction and perpendicular to a plane parallel to the first and second directions D1 and D2), the cell architecture 400 may be configured such that the source/drain regions, the interconnect structure and the 1^{st} backside power rail BPR1 above a horizontal center line of the 1^{st} semiconductor cell 400A is the same as or diagonally symmetric to the source/drain regions, the interconnect structure and the 1^{st} backside power rail BPR1 below a horizontal center line of the 2^{nd} semiconductor cell 400B.

After the 2^{nd} semiconductor cell 400B is obtained in this manner, the 2^{nd} semiconductor cell 400B may be disposed at the right side of the 1^{st} semiconductor cell 400A, which is the same as the semiconductor cell 40, and at least one of the metal line M12 of the 1^{st} semiconductor cell 400A as an output pin thereof and the metal line M13 of the 2^{nd} semiconductor cell 400B as an input pin thereof may be extended in the D1 direction to be connected to each other, thereby forming the cell architecture 400 as shown in FIG. 4B.

Here, the cell architecture 400 may be configured by connecting two same semiconductor cells 40 of FIG. 4A one of which is simply turned upside down (turned upside down may mean mirrored at a plane parallel to the first and third directions D1 and D3, or mirrored at a plane parallel to the first direction and perpendicular to a plane parallel to the first and second directions D1 and D2) without using additional interconnection structures formed in the cell architecture 200 of FIG. 2B and without using a variant cell, that is, the 2^{nd} semiconductor cell 300B of the cell architecture 300 of FIG. 3. Still, like in the cell architecture 300 of FIG. 3, the cell architecture 400 may have the output pin of the 1^{st} semiconductor cell 400A including the meta line M12 horizontally aligned with the input pin of the 2^{nd} semiconductor cell 400B including the metal line M13. Thus, simplicity in cell design and device manufacturing may be enabled, and further, shortening a signal routing path and reducing contact resistance may also be achieved, thereby improving connection performance and a device area gain of a semiconductor device manufactured based on the cell architecture 400.

Referring to FIG. 4C, a cell architecture 400' may be formed by connecting a 3^{rd} semiconductor cell 400C, which is the same as the semiconductor cell 40 of FIG. 4A, to the cell architecture 400 of FIG. 3B. For example, the cell architecture 400' may be configured such that an output pin of the 2^{nd} semiconductor cell 400B is connected to an input pin of the 3^{rd} semiconductor cell 400C.

In forming the cell architecture 400', the 3^{rd} semiconductor cell 400C may disposed at the right side of the 2^{nd} semiconductor cell 400B, and at least one of the metal line M12 of the 2^{nd} semiconductor cell 400B as an output pin thereof and the metal line M13 of the 3^{rd} semiconductor cell 400C as an input pin thereof may be extended in the D1 direction to be connected to each other, thereby forming the cell architecture 400' as shown in FIG. 4C.

Like the cell architecture 400, the cell architecture 400' may also be formed by connecting three same semiconductor cells 40 of FIG. 4A one of which is simply turned upside down without using additional interconnection structures formed in the cell architecture 200 of FIG. 2B and without using a variant cell, that is, the 2^{nd} semiconductor cell 300B of the cell architecture 300 of FIG. 3. Thus, simplicity in cell design and device manufacturing may be enabled, and further, shortening a signal routing path and reducing contact resistance may also be achieved, thereby improving connection performance and a device area gain of a semiconductor device manufactured based on the cell architecture 400'.

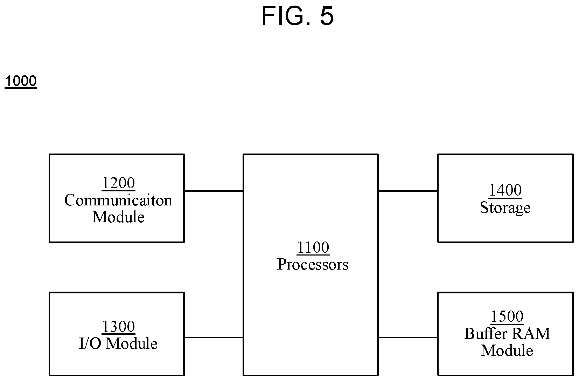

FIG. 5 is a schematic block diagram illustrating an electronic device including at least one semiconductor device based on at least one of the semiconductor cell 40 and the cell architectures 400 and 400' shown in FIGS. 4A-4C, according to embodiments.

Referring to FIG. 5, an electronic device 1000 may include at least one processor 1100, a communication module 1200, an input/output module 1300, a storage 1400, and a buffer random access memory (RAM) module 1500. The electronic device 1000 may be a mobile device such as a smartphone or a tablet computer, not being limited thereto, according to embodiments.

The processor 1100 may include a central processing unit (CPU), a graphic processing unit (GPU) and/or any other processors that control operations of the electronic device 1000. The communication module 1200 may be implemented to perform wireless or wire communications with an external device. The input/output module 1300 may include at least one of a touch sensor, a touch panel a key board, a mouse, a proximate sensor, a microphone, etc. to receive an input, and at least one of a display, a speaker, etc. to generate an output signal processed by the processor 1100. The storage 1400 may be implemented to store user data input through the input/output module 1300, the output signal, etc. The storage 1400 may be an embedded multimedia card (eMMC), a solid state drive (SSD), a universal flash storage (UFS) device, etc.

The buffer RAM module 1500 may temporarily store data used for processing operations of the electronic device 1000. For example, the buffer RAM 1500 may include a volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

Although not shown in FIG. 5, the electronic device 1000 may further include at least one sensor such as an image sensor.

At least one component in the electronic device 1000 may be formed based on at least one of the semiconductor cell 40 and the cell architectures 400 and 400' shown in FIGS. 4A-4C, according to embodiments.

The foregoing is illustrative of example embodiments and is not to be construed as limiting the disclosure. Although a few example embodiments have been described, those skilled in the art will readily appreciate that many modifications are possible in the above embodiments without materially departing from the scope of the appended claims.

## Claims

1. A semiconductor device based on a cell architecture which comprises:
a 1^{st} semiconductor cell (400A); and
a 2^{nd} semiconductor cell (400B) which is connected to the 1^{st} semiconductor cell (400A) in a 1^{st} direction (D1) such that an output pin of the 1^{st} semiconductor cell (400A) is connected to an input pin of the 2^{nd} semiconductor cell (400B),
wherein the 2^{nd} semiconductor cell (400B) is in a form in which the 1^{st} semiconductor cell (400A) is turned upside down.

2. The semiconductor device of claim 1, wherein the output pin of the 1^{st} semiconductor cell (400A) comprises a 1^{st} metal line (M12), and the input pin of the 2^{nd} semiconductor cell (400B) comprises a 2^{nd} metal line (M13),
wherein at least one of the 1^{st} metal line (M12) and the 2^{nd} metal line are extended in the 1^{st} direction (D1), and
wherein the 1^{st} metal line (M12) and the 2^{nd} metal line (M13) are connected to each other.

3. The semiconductor device of claim 2, wherein each of the 1^{st} and 2^{nd} semiconductor cells (400A, 400B) comprises a source/drain region (SD1, SD3) connected to a backside power rail (BPR2) formed at a back side of the cell architecture.

4. The semiconductor device of any one of claim 1 to 3, wherein the 1^{st} semiconductor cell (400A) comprises a 1^{st} portion and a 2^{nd} portion below the 1^{st} portion in a 2^{nd} direction (D2) intersecting the 1^{st} direction (D1), the 1^{st} portion comprising a 1^{st} source/drain region and a 1^{st} interconnect structure,
wherein the 2^{nd} semiconductor cell (400B) comprises a 3^{rd} portion and a 4^{th} portion below the 3^{rd} portion in the 2^{nd} direction (D2), the 4^{th} portion comprising a 2^{nd} source/drain region and a 2^{nd} interconnect structure, and
wherein the 1^{st} portion is the same as or symmetrical to the 4^{th} portion.

5. The semiconductor device of claim 4, wherein the 1^{st} portion is symmetrical to the 4^{th} portion and wherein the 1^{st} portions and the 3^{rd} portion are respectively divided from the 2^{nd} portion and the 4^{th} portion by a virtual horizontal center line extended in the 1^{st} direction (D1) on the 1^{st} and 2^{nd} semiconductor cells (400A, 400B).

6. The semiconductor cell of claim 4 or 5, wherein a polarity of the 1^{st} source/drain region in the 1^{st} portion is the same as a polarity of the 2^{nd} source/drain region in the 4^{th} portion.

7. The semiconductor device of any one of claims 1 to 6, comprising:
a 1^{st} backside power rail along a 1^{st} boundary of the cell architecture;
a 2^{nd} backside power rail (BPR2) along a virtual center line of the cell architecture; and
a 3^{rd} backside power rail along a 2^{nd} boundary of the cell architecture opposite to the 1^{st} boundary in a 2^{nd} direction (D2) intersecting the 1^{st} direction (D1),
wherein the 1^{st} to 3^{rd} backside power rails are extended in the 1^{st} direction (D1).

8. The semiconductor device of claim 7, wherein the 1^{st} and 3^{rd} backside power rails are connected to a 1^{st} voltage source (VDD), and the 2^{nd} backside power rail is connected to a 2^{nd} voltage source (VSS) different from the 1^{st} voltage source (VDD).

9. The semiconductor device of claim 8, wherein the 1^{st} semiconductor cell (400A) comprises a 1^{st} transistor comprising a 1^{st} source/drain region (SD1), and a 2^{nd} transistor comprising a 2^{nd} source/drain region (SD3),
wherein the 2^{nd} semiconductor cell (400B) comprises a 3^{rd} transistor comprising a 3^{rd} source/drain region (SD3), and a 4^{th} transistor comprising a 4^{th} source/drain region (SD1),
wherein the 1^{st} source/drain region (SD1) is connected to the 1^{st} backside power rail, and the 4^{th} source/drain region (SD1) is connected to the 3^{rd} backside power rail, and
wherein the 2^{nd} and 3^{rd} source/drain regions (SD3) are connected to the 2^{nd} backside power rail (BPR2).

10. The semiconductor device of any one of claims 1 to 9, wherein the 1^{st} and 2^{nd} semiconductor cells (400A, 400B) comprise a same logic circuit (10).

11. A semiconductor device based on a cell architecture which comprises:
a 1^{st} semiconductor cell (400A);
a 2^{nd} semiconductor cell (400B) which is connected to the 1^{st} semiconductor cell (400A) such that an output pin of the 1^{st} semiconductor cell (400A) is connected to an input pin of the 2^{nd} semiconductor cell (400B) in a 1^{st} direction (D1); and
at least one backside power rail formed at a back side of the cell architecture,
wherein the 1^{st} semiconductor cell (400A) and the 2^{nd} semiconductor cell (400B) comprise a same logic circuit, and
wherein the 1^{st} semiconductor cell (400A) and the 2^{nd} semiconductor cell (400B) are both connected to at least one backside power rail.

12. The semiconductor device of claim 11, wherein the 2^{nd} semiconductor cell (400B) is in a form in which the 1^{st} semiconductor cell (400A) is turned upside down.

13. The semiconductor device of claim 11 or 12, wherein the output pin and the input pin are aligned with each other in the 1^{st} direction (D1).

14. The semiconductor device of any one of claims 11 to 13, wherein the at least one backside power rail comprises:
a 1^{st} backside power rail along a 1^{st} boundary of the cell architecture;
a 2^{nd} backside power rail (BPR2) along a virtual center line of the cell architecture; and
a 3^{rd} backside power rail along a 2^{nd} boundary of the cell architecture opposite to the 1^{st} boundary in a 2^{nd} direction (D2) intersecting the 1^{st} direction (D1),
wherein the 1^{st} to 3^{rd} backside power rails are extended in the 1^{st} direction (D1).

15. The semiconductor device of any one of claims 11 to 14, wherein the 1^{st} semiconductor cell (400A) comprises a 1^{st} portion and a 2^{nd} portion below the 1^{st} portion in a 2^{nd} direction (D2) intersecting the 1^{st} direction (D1), the 1^{st} portion comprising a 1^{st} source/drain region and a 1^{st} interconnect structure,
wherein the 2^{nd} semiconductor cell (400B) comprises a 3^{rd} portion and a 4^{th} portion below the 3^{rd} portion in the 2^{nd} direction (D2), the 4^{th} portion comprising a 2^{nd} source/drain region and a 2^{nd} interconnect structure, and
wherein the 1^{st} portion is symmetrical to the 4^{th} portion.
